# EUROPEAN PATENT APPLICATION

(11) **EP 2 849 221 A1**
(43) Date of publication of application: **18.03.2015**
(21) Application number: 13183978.9
(22) Date of filing: 11.09.2013
(51) Int. Cl.: H01L 23/373, H01L 23/42, H01L 23/433

(54) **Cooling arrangement for a power semiconductor module**

(71) Applicant: ABB Technology AG, 8050 Zürich (CH)
(72) Inventor: Hartmann, Samuel, 5603 Staufen (CH); Hajas, David, 5102 Rupperswil (CH); Berger, Andreas, 5603 Staufen (CH); Trüssel, Dominik, 5620 Bremgarten (CH)
(74) Representative: ABB Patent Attorneys

(57) **Abstract**

A cooling arrangement (30a, 30b) for a power semiconductor module (10) comprises a thermally emitting surface (22) in thermal contact with at least one power semiconductor (16) of the power semiconductor module (10); a cooling body (24) in thermal contact with the thermally emitting surface (22) adapted for dissipating heat generated by the at least one power semiconductor (16); and a thermally conducting body (26a, 26b), which is arranged between the thermally emitting surface (22) and the cooling body (24), such that the heat emitted from the thermally emitting surface (22) is conducted via the thermally conducting body (26a, 26b) to the cooling body (24). The thermally conducting body (26a, 26b) comprises at least one foil (32, 32a, 32b) and a plastically deformable material (34) adapted for conduction heat, which is prevented to leak from the cooling arrangement (30a, 30b) by the at least one foil (32, 32a, 32b).

## Description

### FIELD OF THE INVENTION

The invention relates to the field of power semiconductor modules. In particular, the invention relates to a cooling arrangement for a power semiconductor module and a method for producing such a cooling arrangement.

### BACKGROUND OF THE INVENTION

Many high power applications, such as inverters, rectifiers, switches, etc., comprise power modules that carry one or more of the high power semiconductors of the respective high power application. Such a power module usually has a substrate such as a DBC (direct bonded copper) with one or more high power semiconductor dies soldered to one side and a base plate soldered to the other side. For cooling the power module, a heat sink or cooling body is attached to the base plate. In particular, insulated power modules are usually mounted to a water-cooled heat sink.

A thermal grease may be used to improve the heat transfer from the base plate to the cooling body. However, the thermal grease may leak out or dry out over time and the cooling performance may degrade.

An alternative to greases are thermal pads. But normally, the thermal pads are not compressive (constant volume) even if they are elastic. Therefore, the thermal pads normally cannot adjust to a varying cavity over the usually large area of the base plate.

### DESCRIPTION OF THE INVENTION

It is an object of the invention to provide an easy to manufacture power module with high cooling capabilities.

This object is achieved by the subject-matter of the independent claims. Further exemplary embodiments are evident from the dependent claims and the following description.

An aspect of the invention relates to a cooling arrangement for a power semiconductor module. A power semiconductor module may comprise at least one die, housing one or more power semiconductors and a substrate onto which the die is mounted. Also further components like terminals and/or conductive paths may be mounted to the substrate. For example, the substrate may comprise one or two conducting layers attached to a ceramics layer, wherein the dies and/or further components are mounted to the conducting layer.

It has to be understood that a power semiconductor module may be an electrical component that is adapted to process currents of more than 10 A and/or more than 100 V.

According to an embodiment of the invention, the arrangement comprises a thermally emitting surface in thermal contact with at least one power semiconductor of the power semiconductor module; a cooling body in thermal contact with the thermally emitting surface adapted for dissipating heat generated by the at least one power semiconductor; and a thermally conducting body, which is arranged between the thermally emitting surface and the cooling body, such that the heat emitted from the thermally emitting surface is conducted via the thermally conducting body to the cooling body.

For example, the thermally emitting surface may be provided by the substrate onto which the at least one power semiconductor is mounted or by a base plate mounted to the substrate.

The cooling body or heat sink may be water-cooled or air-cooled. For example, the cooling body may comprise pipes to receive a cooling liquid (such as water) and/or may comprise fins for dissipating heat into the air.

The thermally conducting body may be used for equalizing unevennesses in the thermally conducting surface and/or the corresponding surface of the cooling body. For example, the thermally emitting surface and/or a cooling surface of the cooling body opposite to the thermally emitting surface may have an area of more than 100 cm². If the two surfaces were mounted on each other without a thermally conducting body, the area adapted for transporting heat between the two surfaces may be smaller due to possible protrusions, ripples or indents in the two surfaces.

According to an embodiment of the invention the thermally conducting body comprises at least one foil and a plastically deformable material adapted for conduction heat, which is prevented to leak from the cooling arrangement by the at least one foil. Between the thermally emitting surface and the cooling body, a cavity may be formed by the foil (and optionally by the thermally emitting surface and/or the cooling body), which accommodates and/or encases the plastically deformable material. In such a way, the leakage of the plastically deformable material from the power semiconductor module may be prevented.

The plastically deformable material may undergo non-reversible deformations, when being pressed between the thermally emitting surface and the cooling body. For example, the plastically deformable material may be a paste, a grease and/or a liquid. For example, the plastically deformable material may comprise heat paste. The plastically deformable material may be a (low) viscous material.

The foil may be a plastics foil, a metal foil or a metal sheet. For example, the foil may be a copper or aluminium foil. Both, the at least one foil and/or the plastically deformable material may comprise copper.

According to an embodiment of the invention, the at least one foil is bonded to the thermally emitting surface, such that the plastically deformable material is arranged between the at least one foil and the thermally emitting surface. Alternatively, the at least one foil is bonded to the cooling body, such that the plastically deformable material is arranged between the at least one foil and the cooling body. In such a way, a cavity encasing the plastically deformable material may be formed by the foil and the thermally emitting surface or the cooling body. For example, the foil may be welded to the thermally emitting surface or the cooling body.

According to an embodiment of the invention, the thermally conducting body comprises two foils completely enclosing the plastically deformable material. It also may be possible that a thermally conducting pad is formed by encasing the plastically deformable material in one or more foils. For example, one foil may be bonded with itself or two foils may be bonded with each other for forming a cavity to accommodate the plastically deformable material. The cavity may be sealed and plastically flowing material may be enclosed between two sealed foils. The pad may be manufactured from the foil and the plastically deformable material before it is sandwiched between the thermally emitting surface and the cooling body.

According to an embodiment of the invention, the at least one foil is at least partially permeable for air, such that air in the plastically deformable material can leave the cooling arrangement. In such a way, gas and/or air bubbles that may be present and/or may be generated in the cavity (at least partially) encased by the foil may leave the space between the thermally emitting surface and the cooling body, which may enhance the thermal conducting area provided by the thermally conducting body.

According to an embodiment of the invention, the thermally emitting surface is provided by a base plate of the semiconductor power module. For example, a substrate carrying one or more dies may be mounted to a base plate of copper or aluminium. The cooling body may be attached to the base plate via the thermally conducting body as described in the above and in the following.

A further aspect of the invention relates to a method for producing a cooling arrangement for a power semiconductor module, for example a power semiconductor module as described in the above and in the following. It has to be understood that features of the method as described in the above and in the following may be features of the cooling arrangement as described in the above and in the following.

According to an embodiment of the invention, the method comprises: positioning at least one foil and a plastically deformable material adapted for conduction heat between a thermally emitting surface and a cooling body adapted for dissipating heat generated by the power semiconductor module; and encasing the plastically deformable material with the at least one foil, the thermally emitting surface and/or the cooling body, such that the plastically deformable material is prevented to leak from the cooling arrangement by the at least one foil. For example, a paste, grease or liquid may be encased in a metal foil or metal sheet that (at least partially or completely) forms a cavity in the power semiconductor module that prevents the plastically deformable material from leaving the power semiconductor module.

According to an embodiment of the invention, for encasing the plastically deformable material, the at least one foil is bonded to itself, to another foil, to the thermally emitting surface and/or to the cooling body. The cavity may be formed by components of the power semiconductor module together with the foil bonded (such as welded) to the respective component. It is also possible that the cavity is formed by one foil bonded with itself or two foils bonded with each other.

According to an embodiment of the invention, the at least one foil is permeable for a gas and encasing the plastically deformable material is carried out in an atmosphere comprising the gas. In such a way, gas that is possible encased into the cavity will leave the cavity afterwards and the cooling capability of the power module may be enhanced. Such gases may be low molecular weight gases. For example, the gas may comprise H₂ and/or He.

Instead of a plastically deformable body that, via a foil, is prevented from leaving the power semiconductor module due to pressing the cooling body against the thermally emitting surface, the thermally conducting body additionally or alternatively may comprise an elastically deformable body that is sandwiched between the thermally emitting surface and the cooling body.

According to an embodiment of the invention, the thermally conducting body comprises an elastic thermal pad provided with pad gaps, such that the thermal pad is deformable by spreading into the pad gaps, when a pressure is applied to the elastic thermal pad sandwiched between the thermally emitting surface and the cooling body. When the cooling body is pressed against the thermally emitting surface, the elastic thermal pad is compressed and may partially deform into the gaps. Since a part of the material of the elastic pad moves into the gaps, the elastic pad may equalize unevennesses over the complete area of the thermally emitting surface and the cooling body.

An elastic pad may be formed of plastics material, which, for example, may comprise metal (copper) particles for enhancing the thermal conductivity. The elastic pad may be a compound material of an elastic plastic material and metal.

The gaps may be arranged in different patterns. For example, the gaps may be provided in hexagonal segmented or unsegmented patterns, in a square pattern or a linear pattern.

According to an embodiment of the invention, the pad gaps are provided such that all parts of the elastic thermal pad are interconnected. For example, the gaps are punched into the elastic pad, such that ridges interconnect all parts of the elastic pad. These ridges may have the same thickness as the other parts of the elastic pad.

However, it is also possible that the pad gaps separate the elastic thermal pad into disconnected parts.

According to an embodiment of the invention, pad gaps completely penetrate the elastic thermal pad from the thermally emitting surface to the cooling body. It may be possible that the gaps have the same thickness as the material of the elastic pad.

According to an embodiment of the invention, pad gaps only partially penetrate the elastic thermal pad. For example, the pad gaps may be grooves in one side of the elastic pad. It may be possible that parts of the elastic pad are attached to a support layer.

It is also possible that the gaps for receiving deformed material of the elastic pad are not provided in the pad but in a (microstructured) surface of the cooling body and/or in the thermally emitting surface.

According to an embodiment of the invention, the thermally conducting body comprises an elastic thermal pad and a structure providing structure gaps, such that the thermal pad is deformable by spreading into the structure gaps, when a pressure is applied to the structure and the elastic thermal pad sandwiched between the thermally emitting surface and the cooling body. The structure gaps may be provided by the thermally emitting surface and/or by the cooling body.

In this case, the elastic pad does not need to be modified and/or may have a rectangular cross section (without gaps).

The structure with the structure gaps may comprise a wavy or sinusoidal surface, which may result in a large initial contact area.

The structure may comprise a triangle structure, which may result in a low initial pressure.

The structure may comprise a ripple structure, which may result in a low pressure needed a higher compressibility. The ripples may be ripples with rounded heads or may be sharp ripples.

According to an embodiment of the invention, the thermally conducting body comprises elastic elements and at least one metal element; wherein the metal element is pressed by the elastic elements against the thermally emitting surface and the cooling body, such that heat conducting connections between the thermally emitting surface and the cooling body are provided by the metal element. The thermally conducting path may be provided by a shaped metal element, which may have a much higher thermal conductivity as an elastic pad. The metal element or metal elements may be wires, a metal sheet or metal stripes that are interwoven with the elastic elements. The elastic elements may be plastic wires, plastic balls or a compressible foam.

For example, the thermally conductive body may be formed by placing a wavy metal sheet provided with elastic elements (such as foam material) between the thermally emitting surface and the cooling body and, after that pressing the thermally conductive body between the thermally emitting surface and the cooling body.

Alternatively or additionally, the thermally conductive body may be formed by placing a planar metal sheet provided with elastic elements between the thermally emitting surface and the cooling body, wherein the thermally conductive body is deformed by pressing it between the thermally emitting surface and the cooling body.

For example, a pre-form of the thermally conductive body may be manufactured by wounding an elastic rubber/plastics wire around a flat or a wavy metal sheet, by casting structured material on both sides of a flat metal sheet, by casting compressible foam in a wavy metal sheet and/or by gluing elastic elements on a metal sheet.

These and other aspects of the invention will be apparent from and elucidated with reference to the embodiments described hereinafter.

### BRIEF DESCRIPTION OF THE DRAWINGS

The subject matter of the invention will be explained in more detail in the following text with reference to exemplary embodiments which are illustrated in the attached drawings.
Fig. 1 schematically shows a cross-sectional view of a power semiconductor module with a cooling arrangement according to an embodiment of the invention.
Fig. 2 schematically shows a cross-sectional view of a cooling arrangement according to an embodiment of the invention.
Fig. 3 schematically shows a cross-sectional view of a cooling arrangement according to a further embodiment of the invention.
Fig. 4 schematically shows a cross-sectional view of a cooling arrangement according to a further embodiment of the invention.
Fig. 5 schematically shows a three-dimensional view of a thermal pad for a cooling arrangement according to an embodiment of the invention.
Fig. 6 schematically shows a three-dimensional view of a thermal pad for a cooling arrangement according to an embodiment of the invention.
Fig. 7 schematically shows an elevational view on a thermal pad for a cooling arrangement according to an embodiment of the invention.
Fig. 8 schematically shows an elevational view on a thermal pad for a cooling arrangement according to an embodiment of the invention.
Fig. 9 schematically shows a cross-sectional view of a cooling arrangement according to a further embodiment of the invention.
Fig. 10 schematically shows a cross-sectional view of the cooling arrangement of Fig. 9 under pressure.
Fig. 11 schematically shows a cross-sectional view of a cooling arrangement according to a further embodiment of the invention.
Fig. 12 schematically shows a cross-sectional view of the cooling arrangement of Fig. 11 under pressure.
Fig. 13 schematically shows a cross-sectional view of a cooling arrangement according to a further embodiment of the invention.

The reference symbols used in the drawings, and their meanings, are listed in summary form in the list of reference symbols. In principle, identical parts are provided with the same reference symbols in the figures.

### DETAILED DESCRIPTION OF EXEMPLARY EMBODIMENTS

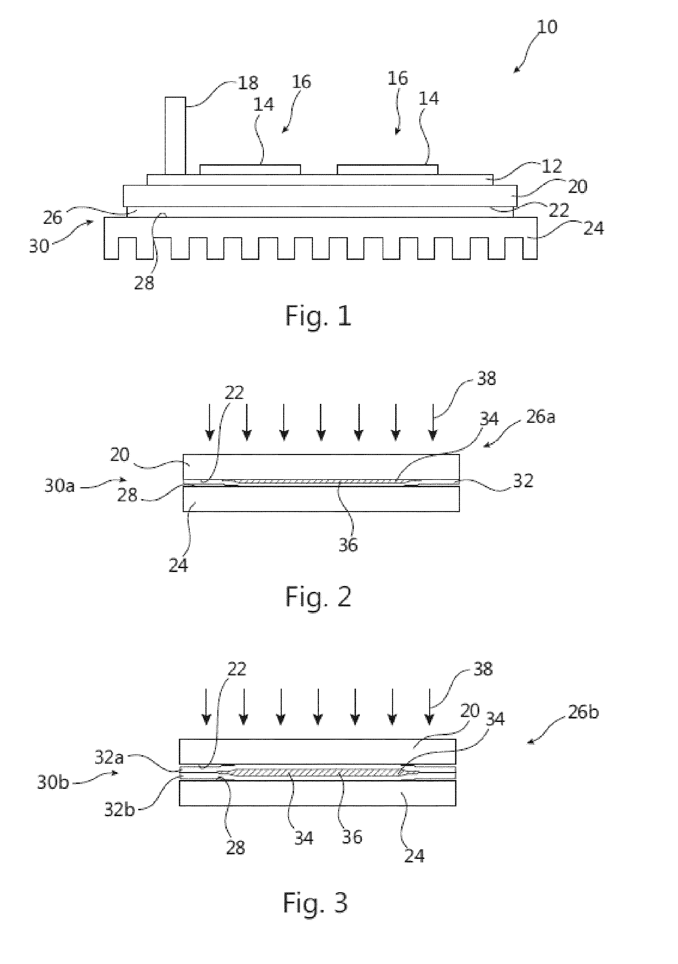

Fig. 1 shows a power semiconductor module 10 comprising a substrate 12 carrying dies 14 with power semiconductors 16 on one side. The substrate 12 furthermore may carry further components, such as, for example, terminals 18. For example, the substrate 12 is a DCB with two layers of copper sandwiching a ceramics plate. The components 14, 18 usually are bonded to the substrate 12, for example by soldering.

On the other side of the substrate 12, a base plate 20 may be bonded to the substrate 12, for example by soldering. The base plate 20 is in thermal contact with the dies 14 and the power semiconductors 16 via the substrate 12 and provides a thermally emitting surface 22, which is used for dissipating heat from the power semiconductor module 10. However, it is not necessary that the power semiconductor module 10 comprises a separate base plate 20 and the thermally emitting surface 22 may be provided by the substrate 12.

A heat sink or cooling body 24 is in thermal contact with the thermally emitting surface 22 via a thermally conducting body 26 sandwiched between the thermally emitting surface 22 and an opposite surface 28 of the cooling body 24.

The cooling body 24, for example, may be a water-cooled body with inner pipes for conducting water or may be an air or gas-cooled body with fins.

The surfaces 22, 28 are substantially plane but usually have unevennesses, such as protrusions, sinks and/or ripples, that, for example, are generated during manufacturing of the components 20 and 26. The thermally conducting body 26 on the one hand is adapted for equalizing these unevennesses, such that it is in direct contact to nearly the whole area of the two surfaces 22, 28 and on the one hand is adapted for transferring heat from the surface 22 to the surface 28. Thus, the thermally conducting body 26 comprises material with a high heat conductivity. The thermally conducting body 26 may be seen as an interface adjustable to variations of the cavity formed by the two surfaces 22, 28.

Embodiments of the cooling arrangement 30 of the power semiconductor module 10 will be described in the following.

Fig. 3 shows a cooling arrangement 30a with a thermally conducting body 26a comprising a foil 32 and a plastically deformable material 34, such as low viscous heat paste. The foil 32, which may be a metal foil or metal sheet, is bonded to the surface 22 (or alternatively to the surface 28), for example via gluing, welding, soldering, etc., such that a cavity 36 is formed for encasing or enclosing the plastically deformable material 34.

The foil 32 may be seen as a seal for the cavity 36. In the cooling arrangement 30a, the sealed cavity 36 is formed from the foil 32 and the surface 22 (or 28).

When a (defined) pressure (indicated by arrows 38) is applied to the cooling arrangement 30a substantially orthogonal to the surfaces 22, 28, the plastically deformable material 34 spreads between the surfaces 22, 28 in the cavity 34 but is hindered by the foil 32 from leaking from the cooling arrangement 30a.

Fig. 3 shows a cooling arrangement 30b with a thermally conducting body 26b comprising two foils 32a, 32b (which may be metal foils or metal sheets) that are bonded with each other to form a cavity 34 for a plastically deformable material 34. Here, two foils 32a, 32b may form a seal for the plastically deformable material 34.

It may be possible that the foils 32, 32a, 32b are permeable for a specific gas (such as hydrogen or helium) and the encasing of the plastically deformable material 34 is carried out in an atmosphere comprising the gas. H₂ and He are gases with very small molecular or atomic size, respectively. These gases penetrate easily through small leaks.

When the foil 32 is bonded to the surface 22 (or 28) or the foils 32a, 32b are bonded with each, then there is no need for evacuating the cavity 36 during production, since residual gas may leave through the foils 32, 32a, 32b.

It is also possible that the foils 32, 32a, 32b are permeable for air.

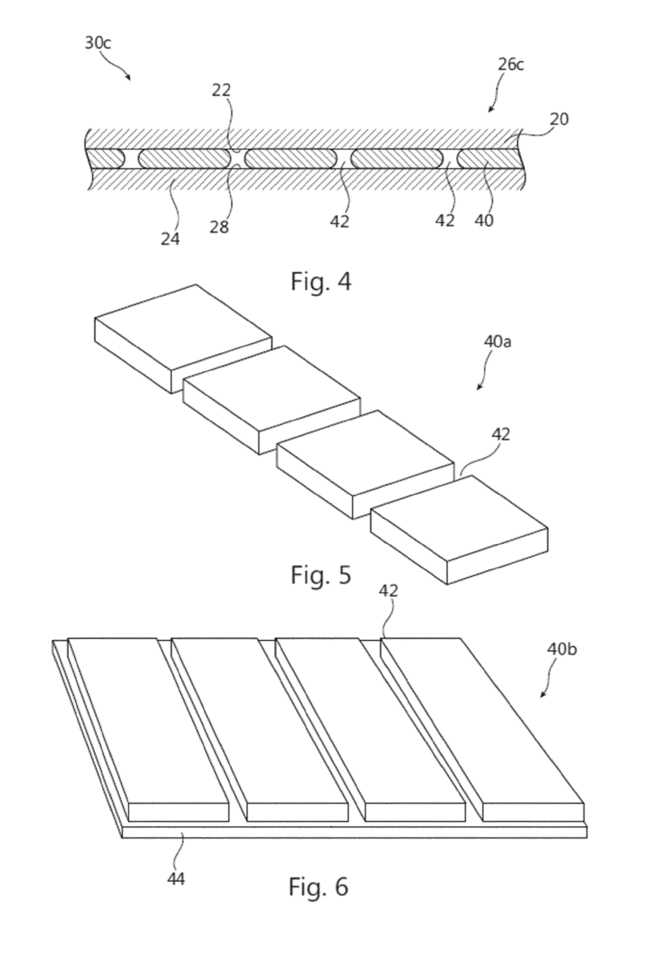

Fig. 4 shows a cooling arrangement 30c with a thermally conducting body 26c comprising an elastic thermal pad 40. Gaps 42 are provided in the thermal pad 40 that allow the thermal pad 40 to elastically deform into the gaps, when a pressure is applied to the cooling arrangement 30c. As shown in Fig. 4, the gaps 42 penetrate through the whole thickness of the elastic thermal pad 40.

For example, the pad 40 may have a thickness of about 100 µm. The gaps may be about 100 µm wide. The parts of the pad 40 may have an extension of about 500 µm.

As a further example, the thermal pad 40 may be manufactured from rubber. When compressed by 20 µm, the maximum deformation may be about 100% which typically is possible with rubbers. A simulation has shown that such a compression may be achieved with a pressure of about 2 MPa and an elastic modulus of the pad lower than 0.5 MPa.

Fig. 5 shows an embodiment of an elastic thermal pad 40a that comprises disconnected parts or segments. The parts may have a rectangular or square area (for example about 500 µm times 500 µm), i.e. the pad 40a may be arranged in a rectangular or square pattern. The pad 40a may have a thickness of about 100 µm. The gaps 42 may be about 100 µm wide.

Fig. 6 shows an elastic thermal pad 40b that comprises connected parts or segments that are arranged in a linear pattern. Again, the pad 40a may have a thickness of about 100 µm and the gaps 42 may be about 100 µm wide.

The pad 40b comprises an enforcement layer 44 that interconnects the parts of the pad 40. Thus, the gaps 42 may be grooves in the pad 40b. The enforcement layer 44 may be one piece with the part of the pad 40b.

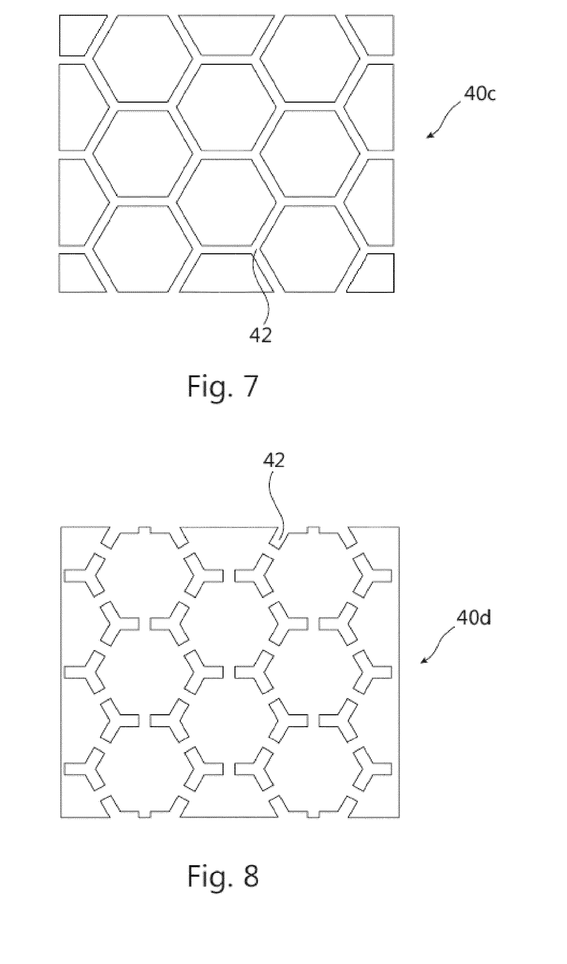

Figs. 7 and 8 show elastic thermal pads 40c, 40d that are hexagonal structured, i.e. have a hexagonal gap pattern. In Fig. 7, the gaps 42 are interconnected. In Fig. 8, gaps 42 are disconnected with ridges or connections between them that interconnect parts of the pad 40d.

In general, typically 1 MPa of pressure is available for elastic deformation of the pads 40, 40a, 40b, 40c, 40d. The material of the pads 40, 40a, 40b, 40c, 40d may have an elastic modulus from below 1 MPa up to a few (such as 2 to 5) MPa (which may depend on a desired compression, a pressure available and a thermal pad structure).

It is possible that the pad 40, 40a, 40c, 40d does not have a support layer. In this case, however, the gaps 42 must not separate the pad into parts (see Fig. 8).

It is possible that the pad 40b, 40c, 40d comprises a support and/or enforcement layer 44 (which may be manufactured from the pad by carving or cutting gaps 42 into a plate-like pad or by attaching parts or segments to the layer 44). The layer 44 may be positioned on one side of the pad (top or bottom). A layer 44 in the middle may hinder strong deformations.

The pads may be manufactured by cutting slits into a pad and stretching the pad to form gaps, by punching gaps, by gluing parts of a pad onto a support layer and/or by etching a gap pattern.

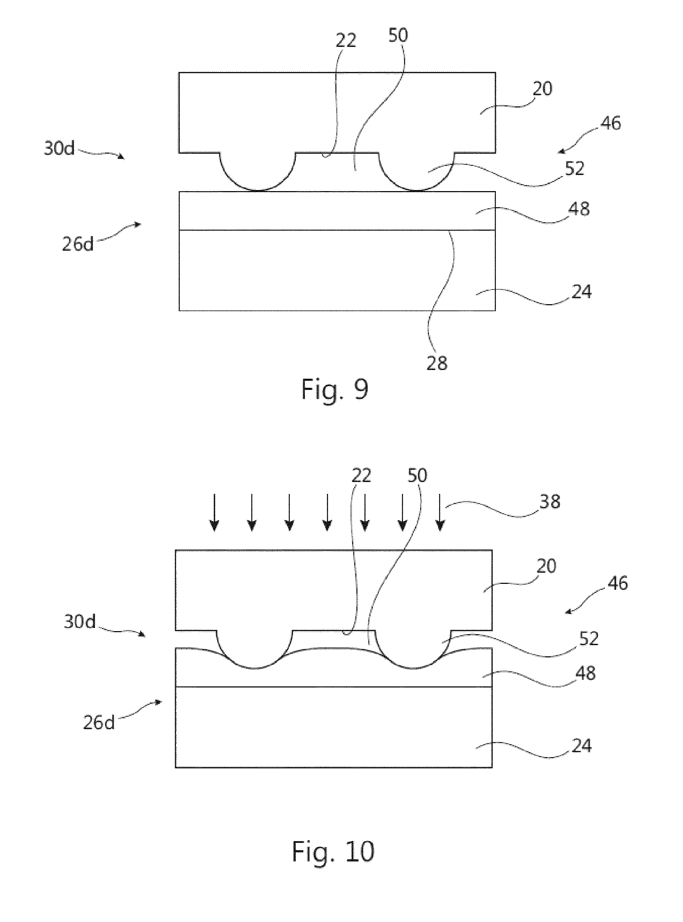

Figs. 9 and 10 show a cooling arrangement 30d with a structure 46 besides an elastic thermal pad 48 that provides gaps 50 in which the pad 48 can deform, when the cooling arrangement is set under pressure (see Fig. 10). The thermally conduction body 30e is provided by the structure 46 together with the pad 48.

While the pads 40 to 40d of the previous embodiments are structured, the pad 48 needs not be structured but may be formed like a plate.

As shown, the structure 46 with gaps 50 may be provided by the thermally emitting surface 22 (for example the base plate 20), but also may be provided by the cooling body 24 or may be a separate member of the cooling arrangement 30d (such as a grill). For example, the structure 46 may be created by machining and/or etching the surface 22 and/or the surface 28.

The structure 46 may be a microstructured surface. The structure 46 may be sinusoidal, may have protrusions 52 with sharp tips or with rounded tips (as shown) and/or may have grooves for forming the gaps 50.

As an example, the pad 48 of Fig. 9 may have a thickness of about 50 µm. In Fig. 9, the structure 46 is pressed about 25 µm into the pad 48. A simulation shows that the compression may be achieved with a pressure that is only 9.1% of the elastic modulus of the thermal pad 48. The deformation of the pad is 42%.

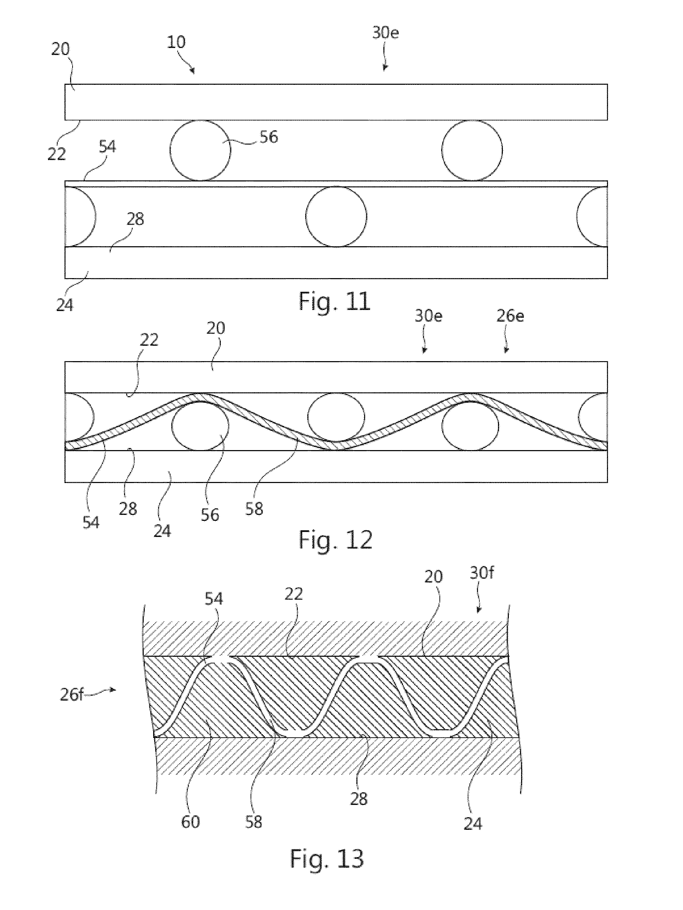

Figs. 11 and 12 show a cooling arrangement 30e with a metal sheet 54 (for example of copper) with elastic elements 56 on both sides, which provide the thermally conducting body 26e. For example, the elastic elements 56 may be a plastic wire wound around the metal sheet 54 or plastic balls, members glued to the metal sheet 54. As shown in Figs. 11 and 12, the elastic elements 56 may be arranged alternating on both sides of the metal sheet 54.

Fig. 11 shows the cooling arrangement 30e before and Fig. 12 shows the cooling arrangement 30e after the application of pressure. The metal sheet 24 may be plane and may be bent into a wavy metal sheet by the elastic elements 56. When kept under pressure, the elastic elements press the metal sheet 54 against the surface 22 and the surface 28, such that conduction paths/connections 58 are formed between the two surfaces 22, 28.

Fig. 13 shows a cooling arrangement 30f with a thermally conducting body 26f that may be preformed before sandwiched between the surfaces 22, 28. The thermally conducting body comprises a structure metal sheet 54 (that for example may be wavy), wherein the space between the conducting paths formed in the metal sheet 54 is at least partially filled with a compressible and/or elastic foam 60. The compressible foam 60 supports the metal sheet 54 and presses the metal sheet 54 against the surfaces 22, 28, when the cooling arrangement 30f is set under pressure.

Both thermal conduction bodies 26e, 26f may have a thickness of about 100 µm and/or a wavelength of the metal sheet 54 of about 200 µm.

Since a metal-like copper may have a much higher heat conductivity than a thermal pad manufactured from plastics material, the heat conductivity of the thermal conduction body 26e, 26f may be as high as the embodiments shown in the previous Figures.

For example, a simulation has shown that the expected heat transfer coefficient for the thermally conducting bodies 26e, 26f may be h = 280'000 W / (m²K). This is extremely high compared to normally observed heat transfer coefficients of around 40'000 W / (m²K). The high number may be due to the fact that the thermal conductivity of a copper sheet 54 is 400 W/(mK) which is extremely high compared to 1 W/(mK) of typical thermal pastes.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art and practising the claimed invention, from a study of the drawings, the disclosure, and the appended claims. In the claims, the word "comprising" does not exclude other elements or steps, and the indefinite article "a" or "an" does not exclude a plurality. A single processor or controller or other unit may fulfil the functions of several items recited in the claims. The mere fact that certain measures are recited in mutually different dependent claims does not indicate that a combination of these measures cannot be used to advantage. Any reference symbol in the claims should not be construed as limiting the scope.

### LIST OF REFERENCE SYMBOLS

- 10: power semiconductor module
- 12: substrate
- 14: die
- 16: power semiconductor
- 18: terminal
- 20: base plate
- 22: thermally emitting surface
- 24: cooling body
- 26, 26a, 26b, 26c, 26d, 26e, 26f: thermally conducting body
- 28: surface of cooling body
- 30, 30a, 30b, 30c, 30d, 30e, 30f: cooling arrangement
- 32, 32a, 32b: foil
- 34: plastically deformable material
- 36: cavity
- 38: pressure
- 40, 40a, 40b, 40c, 40d: elastic thermal pad
- 42: gap
- 44: support layer
- 46: structure
- 48: elastic thermal pad
- 50: gap
- 52: protrusion
- 54: metal sheet
- 56: elastic element
- 58: thermal conducting connections
- 60: compressible foam

## Claims

1. A cooling arrangement (30a, 30b) for a power semiconductor module (10), the arrangement comprising:
a thermally emitting surface (22) in thermal contact with at least one power semiconductor (16) of the power semiconductor module (10);
a cooling body (24) in thermal contact with the thermally emitting surface (22) adapted for dissipating heat generated by the at least one power semiconductor (16); and
a thermally conducting body (26a, 26b), which is arranged between the thermally emitting surface (22) and the cooling body (24), such that the heat emitted from the thermally emitting surface (22) is conducted via the thermally conducting body (26a, 26b) to the cooling body (24);
wherein the thermally conducting body (26a, 26b) comprises at least one foil (32, 32a, 32b and a plastically deformable material (34) adapted for conduction heat, which is prevented to leak from the cooling arrangement (30a, 30b) by the at least one foil (32, 32a, 32b).

2. The cooling arrangement (30a, 30b) of claim 1,
wherein the at least one foil (32, 32a, 32b) comprises at least one metal sheet, and/or
wherein the plastically deformable material (34) comprises heat paste.

3. The cooling arrangement (30a) of claim 1 or 2,
wherein the at least one foil (32) is bonded to the thermally emitting surface (22), such that the plastically deformable material (34) is arranged between the at least one foil (32) and the thermally emitting surface (22); or
wherein the at least one foil (32) is bonded to the cooling body (24), such that the plastically deformable material (34) is arranged between the at least one foil (32) and the cooling body (24).

4. The cooling arrangement (30b) of one of the preceding claims,
wherein the thermally conducting body (30b) comprises two foils (32a, 32b) completely enclosing the plastically deformable material (34).

5. The cooling arrangement (30a, 30b) of one of the preceding claims,
wherein the at least one foil (32, 32a, 32b) is at least partially permeable for air, such that air in the plastically deformable material (34) can leave the cooling arrangement (30a, 30b).

6. The cooling arrangement (30a, 30b) of one of the preceding claims,
wherein the thermally emitting surface (22) is provided by a base plate (20) of the semiconductor power module (10).

7. A method for producing a cooling arrangement (30a, 30b) for a power semiconductor module (10), the method comprising:
positioning at least one foil (32, 32a, 32b) and a plastically deformable material (34) adapted for conduction heat between a thermally emitting surface (22) and a cooling body (24) adapted for dissipating heat generated by the power semiconductor module (10);
encasing the plastically deformable material (34) with the at least one foil (32, 32a, 32b), the thermally emitting surface (22) and/or the cooling body (24), such that the plastically deformable material (34) is prevented to leak from the cooling arrangement (30a, 30b) by the at least one foil (32, 32a, 32b).

8. The method of claim 7,
wherein, for encasing the plastically deformable material (34), the at least one foil is bonded to itself, to another foil, to the thermally emitting surface (22) and/or to the cooling body (24).

9. The method according to claim 7 or 8,
wherein the at least one foil (32, 32a, 32b) is permeable for a gas and encasing the plastically deformable material (34) is carried out in an atmosphere comprising the gas.

10. The method according to claim 9,
wherein the gas comprises H₂ and/or He.

11. A cooling arrangement (30c, 30d) for a power semiconductor module (10), the arrangement comprising:
a thermally emitting surface (22) in thermal contact with at least one power semiconductor (16) of the power semiconductor module (10);
a cooling body (24) in thermal contact with the thermally emitting surface (22) adapted for dissipating heat generated by the at least one power semiconductor (16); and
a thermally conducting body (26c, 26d), which is arranged between the thermally emitting surface (22) and the cooling body (24), such that the heat emitted from the thermally emitting surface (22) is conducted via the thermally conducting body (26c, 26d) to the cooling body (24);
wherein the thermally conducting body (26c) comprises an elastic thermal pad (40, 40a, 40b, 40c, 40d) provided with pad gaps (42), such that the thermal pad is deformable by spreading into the pad gaps (42), when a pressure is applied to the elastic thermal pad sandwiched between the thermally emitting surface (22) and the cooling body (24); and/or
wherein the thermally conducting body (26d) comprises an elastic thermal pad (48) and a structure (46) providing structure gaps (50), such that the elastic thermal pad (48) is deformable by spreading into the structure gaps (50), when a pressure is applied to the structure (46) and the elastic thermal pad (48) sandwiched between the thermally emitting surface (22) and the cooling body (24).

12. The cooling arrangement (30c) of claim 11,
wherein the pad gaps (42) are provided such that all parts of the elastic thermal pad (40b, 40d) are interconnected; or
wherein the pad gaps (42) separate the elastic thermal pad (40a, 40c) into disconnected parts.

13. The cooling arrangement (30c) of one claims 11 or 12,
wherein pad gaps (42) completely penetrate the elastic thermal pad (40, 40a) from the thermally emitting surface to the cooling body; and/or
wherein pad gaps (42) only partially penetrate the elastic thermal pad (40b).

14. The cooling arrangement (30d) of one of the claims 11 to 13,
wherein the structure (46) with the structure gaps (50) is provided by the thermally emitting surface (22) and/or the cooling body (24).

15. A cooling arrangement (30e, 30f) for a power semiconductor module (10), the arrangement comprising:
a thermally emitting surface (22) in thermal contact with at least one power semiconductor (16) of the power semiconductor module (10);
a cooling body (24) in thermal contact with the thermally emitting surface (22) adapted for dissipating heat generated by the at least one power semiconductor (16); and
a thermally conducting body (26e, 26f), which is arranged between the thermally emitting surface (22) and the cooling body (24), such that the heat emitted from the thermally emitting surface (22) is conducted via the thermally conducting body (26e, 26f) to the cooling body (24);
wherein the thermally conducting body (26e, 26f) comprises elastic elements (56, 60) and at least one metal element (54);
wherein the metal element (54) is pressed by the elastic elements (56, 60) against the thermally emitting surface (22) and the cooling body (24), such that heat conducting connections (58) between the thermally emitting surface (22) and the cooling body (24) are provided by the metal element (54).
